# EUROPÄISCHE PATENTSCHRIFT

(11) **EP 2 847 805 B1**
(45) Veröffentlichungstag und Bekanntmachung des Hinweises auf die Patenterteilung: **26.07.2017**
(21) Anmeldenummer: 13718184.8
(22) Anmeldetag: 22.04.2013
(51) Int. Cl.: H01L 41/273

(54) **VERFAHREN ZUR HERSTELLUNG EINES VIELSCHICHTBAUELEMENTS UND DURCH DAS VERFAHREN HERGESTELLTE VIELSCHICHTBAUELEMENT**
METHOD FOR PRODUCING A MULTI-LAYERED STRUCTURAL ELEMENT, AND A MULTI-LAYERED STRUCTURAL ELEMENT PRODUCED ACCORDING TO SAID METHOD
PROCÉDÉ DE PRODUCTION D'UN ÉLÉMENT MULCICOUCHE ET ÉLÉMENT MULTICOUCHE PRODUIT SELON CE PROCÉDÉ

(30) Priorität: 07.05.2012 DE 102012103994
(43) Veröffentlichungstag der Anmeldung: 18.03.2015
(73) Patentinhaber: Epcos AG, 81669 München (DE)
(72) Erfinder: OTTLINGER, Marion, 8530 Deutschlandsberg (AT); FRITZ, Marlene, 8041 Graz (AT)
(74) Vertreter: Epping - Hermann - Fischer
(86) Internationale Anmeldenummer: PCT/EP2013/058299
(87) Internationale Veröffentlichungsnummer: WO 2013/167368

(56) Entgegenhaltungen:
- DE-A1-102010 020 192
- US-A1- 2002 149 297

## Beschreibung

Es wird ein Verfahren zur Herstellung eines dielektrischen Vielschichtbauelements angegeben, bei dem ein Stapel aus dielektrischen Grünfolien, mindestens einer Lage enthaltend ein Hilfsmaterial und Schichten aus Elektrodenmaterial gebildet, entbindert und gesintert wird. Zudem wird ein durch das Verfahren hergestelltes Vielschichtbauelement beansprucht.

Mit dem Verfahren kann beispielsweise ein Piezoaktor hergestellt werden, der zum Betätigen eines Einspritzventils in einem Kraftfahrzeug eingesetzt werden kann.

Die Zuverlässigkeit von piezoelektrischen Vielschichtbauelementen hängt von der Beherrschung von möglicherweise bei ihrer Herstellung auftretenden Rissen ab. Solche Risse können beispielsweise während thermischen Prozessen, wie Sintern, Metallisieren und Löten oder bei der Polarisation auftreten, da aufgrund von unterschiedlichen Dehnungen in verschiedenen Bereichen des Bauelements elastische Spannungen entstehen. Bevorzugt treten diese Risse im Betrieb in der Anwendung auf. Risse, die während der thermischen Prozesse, beim Metallisieren oder Löten auftreten, sind untergeordnet und werden nach Durchführung entsprechender Prozesskontrollen nicht weiter verarbeitet. Solche so genannten Entlastungsrisse oder Polungsrisse können weiterhin abknicken, senkrecht zu den Elektroden verlaufen und damit beispielsweise zwei Elektroden überbrücken, was zu einem Kurzschluss und zu einem Versagen des Bauelements führt.

Es ist eine zu lösende Aufgabe, ein Verfahren zur Herstellung eines dielektrischen Vielschichtbauelements anzugeben, das eine erhöhte Zuverlässigkeit aufweist. Diese Aufgabe wird durch ein Verfahren gemäß dem Patentanspruch 1 gelöst. Weitere Ausführungsformen des Verfahrens sind Gegenstand weiterer Patentansprüche. Zudem wird ein durch das Verfahren hergestelltes Vielschichtbauelement bereitgestellt.

Es wird ein Verfahren zur Herstellung eines dielektrischen Vielschichtbauelements bereitgestellt, das die Schritte umfasst:
A) Bereitstellen eines Elektrodenmaterials und von Grünfolien enthaltend ein dielektrisches Material,
B) Bereitstellen eines Hilfsmaterials, das mindestens ein Kupferoxid enthält,
C) Bilden eines Stapels (1), in dem abwechselnd dielektrische Grünfolien, mindestens eine Lage enthaltend das Hilfsmaterial und Schichten enthaltend das Elektrodenmaterial übereinander angeordnet sind,
D) Entbindern und Sintern des Stapels (1),
   wobei während des Verfahrensschritts D) das Kupferoxid zu dem Kupfermetall reduziert wird und die mindestens eine Lage abgebaut wird, so dass, ein Vielschichtbauelement aus dielektrischen Keramikschichten mit dazwischen angeordneten Innenelektroden, und mindestens einer Schwächungsschicht entsteht. "Abwechselnd" in Bezug auf den im Verfahrensschritt C) gebildeten Stapel kann auch bedeuten, dass nicht auf jeder Grünfolie eine Schicht aus Elektrodenmaterial oder eine Lage aus Hilfsmaterial aufgebracht wird. Beispielsweise können einige piezoelektrische Grünfolien übereinander angeordnet sein, zwischen denen sich keine Schichten aus Elektrodenmaterial befinden.

Die Schichten aus Elektrodenmaterial bilden im fertigen Vielschichtbauelement die Innenelektroden und können beispielsweise mittels eines Siebdruckverfahrens als Metallpaste auf die Grünfolien aufgebracht werden.

Werden mehr als eine Lage enthaltend das Hilfsmaterial im Verfahrensschritt C) in dem Stapel angeordnet, können diese in regelmäßigen oder unregelmäßigen Abständen in dem Stapel vorhanden sein. Die Lagen enthaltend das Hilfsmaterial können gemäß einer Ausführungsform parallel oder weitgehend parallel zu zwei Schichten enthaltend Elektrodenmaterial und angrenzend an zwei Grünfolien angeordnet sein.

Mit dem Verfahren kann die Bildung von Bereichen in dem Vielschichtbauelement, in denen sich Risse bilden können, dadurch gezielt gesteuert werden, dass sich die Lage enthaltend das Hilfsmaterial während des Verfahrens abbaut. Durch den Abbau des Hilfsmaterials ist dieses in dem fertigen Bauelement weitgehend oder vollständig nicht mehr vorhanden, während sich an der Position der Lage eine Schwächungsschicht ausbildet, in deren Bereich eine Sollbruchstelle in dem Vielschichtbauelement vorhanden ist. Wenn sich Risse ausbilden, treten sie im Bauelement im Bereich der Schwächungsschicht aus. Das Ausbilden unkontrollierter Risse kann somit vermindert oder verhindert werden.

Der im Verfahrensschritt C) gebildete Stapel wird anschließend verpresst und dann die Grünfolien, die zumindest eine Lage enthaltend das Hilfsmaterial und die Schichten aus Elektrodenmaterial im Verfahrensschritt D) gemeinsam entbindert und gesintert, so dass ein Vielschichtbauelement aus dielektrischen Schichten mit dazwischen angeordneten Innenelektroden und mindestens einer Schwächungsschicht entsteht.

Gemäß einer Ausführungsform können das Elektrodenmaterial und das Hilfsmaterial so gewählt werden, dass beide Kupfer enthalten, wobei das Kupfer in dem Elektrodenmaterial zu einem geringeren Anteil vorhanden ist als in dem Hilfsmaterial. Der Begriff "Kupfer" ist in diesem Zusammenhang als allgemeine Bezeichnung zu verstehen, und umfasst somit beispielsweise reines Kupfermetall, Kupferlegierungen und Kupferkationen, unabhängig von ihren Aggregatszuständen. Die Begriffe "Kupfermetall" und "Kupferlegierungen" sind Kupfer mit der Oxidationszahl 0 zugeordnet. Der Begriff "Kupferoxid" bezeichnet CuO (Oxidationszahl des Kupfers: 2) und/oder Cu₂O (Oxidationszahl des Kupfers: 1). Das Hilfsmaterial enthält mindestens ein Kupferoxid, vorzugsweise CuO oder Cu₂O, insbesondere bevorzugt CuO.

Unter "zu einem geringeren Anteil" soll verstanden werden, dass die Gesamtkonzentration des Kupfers in dem Elektrodenmaterial geringer ist als in dem Hilfsmaterial. Dieser Konzentrationsunterschied bewirkt, dass während des Entbinderns und Sinterns im Verfahrensschritt D) eine Diffusion des Kupfers von der Lage zu mindestens einer der Schichten enthaltend Elektrodenmaterial stattfinden kann. Diese Diffusion erfolgt dabei durch die der Lage benachbarten dielektrischen Schichten. Die Diffusion des Kupfers ist bereits während des Entbinderns, d.h. bei Temperaturen unterhalb von 600°C möglich, wenn das Kupfer in dem Hilfsmaterial als Kupferoxid vorliegt. Die Diffusion des Kupfers wird besonders begünstigt, wenn das Kupfer in dem Hilfsmaterial als CuO (Oxidationszahl 2) vorliegt. Die Mobilität des Kupfers in den dielektrischen Schichten ist durch den Konzentrationsunterschied als treibende Kraft gegeben. Vorzugsweise enthält das Hilfsmaterial kein Kupfermetall (Oxidationszahl 0). Insbesondere bevorzugt besteht das Hilfsmaterial nur aus einer Komponente.

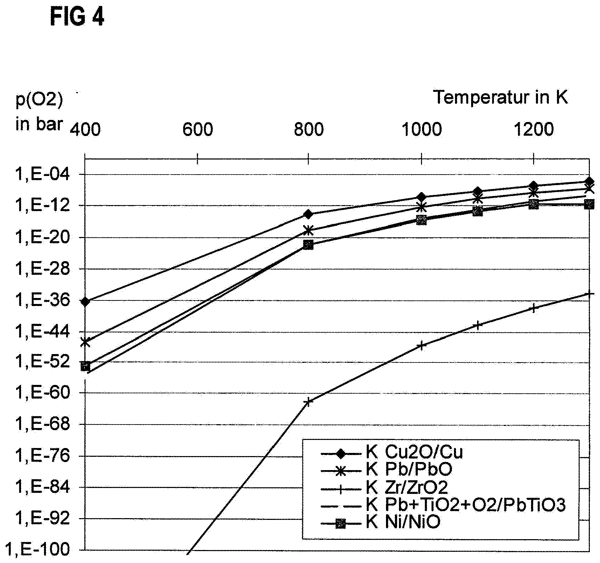

Vorzugsweise wird der Sauerstoffpartialdruck während des Entbinderns und Sintern so eingestellt, dass das Kupferoxid (Oxidationszahl 1 oder 2) zu Kupfermetall (Oxidationsstufe 0) reduziert wird. Hierzu wird beim Entbindern und Sintern der das Prozessfenster jeweils so eingestellt, dass der sich einstellende Gleichgewichtspartialdruck des Sauerstoffs zwischen den Kurven Pb/PbO und Cu₂O/Cu (so dass gleichzeitig PbO und Cu existent sind) liegt (vgl. Figur 4). Vorzugsweise wird der Sauerstoffpartialdruck beim Entbindern auf einen Wert von pO₂ = 10⁻¹⁸ - 10⁻¹³ atm bei 600 °C; und auf einen Wert von pO₂ = 10⁻⁴⁰ - 10⁻³⁵ atm bei 200 °C eingestellt. Das Sintern wird vorzugsweise bei einer Temperatur von 1010°C innerhalb der Gleichgewichtskurven von Cu₂O/Cu und Pb/PbO (vgl. Figur 4) durchgeführt. Die Atmosphäre wird beim Sintern vorzugsweise aus einer Mischung von H₂O/ N₂ und H₂ eingestellt.

In einer Ausführungsform ist die Reduktion des Kupferoxids zu dem Kupfermetall (Oxidationsstufe 0) nach dem Entbinderungsverfahren, d.h. bei Temperaturen unterhalb von 600°C, weitgehend abgeschlossen. Die entsprechenden Untersuchungen wurden mit Rasterelektronenmikroskopie in Kombination mit EDX durchgeführt. Die Probe vor dem Entbindern zeigte deutlich die Existenz von metallischem Cu neben Cu₂O und CuO in der entsprechenden Bedruckungsschicht. Nach dem Entbindern konnte an dieser Stelle nur noch metallisches Cu mit minimaler oberflächlicher Oxidation nachgewiesen werden.

Das Verfahren ermöglicht es also, gezielt das Hilfsmaterial abzubauen und so eine Schwächungsschicht aufzubauen, ohne dabei das Metall in dem Elektrodenmaterial anzugreifen.

In herkömmlichen Methoden, worin eine über die Sinteratmosphäre gesteuerte Oxidation des Hilfsmaterials durchgeführt wird, ist eine räumlich gezielte Oxidation nicht verwirklichbar, da die Oxidation auch an dem Elektrodenmaterial stattfindet, was unerwünscht ist, da einerseits oxidiertes Elektrodenmaterial wegdiffundieren und damit die Elektrodenschicht auflösen kann und andererseits die Lage, die zur Schwächungsschicht gebildet werden soll, nicht vollständig abgebaut werden kann.

Weiterhin können im Verfahrensschritt D) die Kupferionen (Oxidationsstufe 1 oder 2) zu mindestens einer der Schichten enthaltend Elektrodenmaterial hin diffundieren.

Unter "hindiffundieren" soll verstanden werden, dass die Kupferionen soweit diffundieren, bis sie zu Kupfermetall reduziert werden. Wenn die Reduktion vollständig abgelaufen sind, ist nur noch Kupfermetall vorhanden, das kaum diffundieren kann. Damit können also die Kupferoxide, in denen das Kupfer in Oxidationsstufe 1 oder 2 vorliegt, zu dem Elektrodenmaterial hin diffundieren. In diesem Fall diffundiert das Metall als Kation. Wegen der höheren Mobilität der zweiwertigen im Vergleich zu den einwertigen Kupferionen ist CuO gegenüber Cu₂O bevorzugt.

Durch die Reduktion und gegebenenfalls Diffusion der Kupferionen aus dem Kupferoxid wird im Bereich der das Hilfsmaterial enthaltenden Lage in dem Stapel eine Schwächungsschicht gebildet. Im Bereich der Lage bildet sich also eine poröse Schwächungsschicht, die auch als Schwächungsbereich verstanden werden kann. Eine Schwächungsschicht bedeutet hierbei eine Lage mit im Vergleich zu den übrigen dielektrischen Schichten des Vielschichtbauelements verminderter Bruchfestigkeit. Die Bruchfestigkeit wird hierbei durch geeignete Auswahl des Hilfsmaterials (Verhältnis von CuO zu Cu₂O; Menge und Körnungsgröße des Kupferoxids) vorzugsweise so eingestellt, dass Spannungsrisse im Vielschichtbauelement entlang der Schwächungsschicht verlaufen, wobei dabei die Festigkeit des Vielschichtelements nicht beeinträchtigt wird. Im Einzelnen wird die Lage, die vor dem Verfahrensschritt D) das Hilfsmaterial enthielt, abgebaut, indem das Kupferoxid aus dem Hilfsmaterial beim Entbindern zu Kupfermetall reduziert wird und gegebenenfalls in Richtung der Elektrodenschichten diffundiert.

Gemäß einer Ausführungsform enthält das Elektrodenmaterial Kupfer, vorzugsweise Kupfermetall oder eine Kupferlegierung.

Gemäß einer Ausführungsform wird als dielektrisches Material ein piezoelektrisches Material verwendet. Beispielsweise kann als Keramikmaterial das Blei-Zirkonat-Titanat-System (Pb(ZrₓTi₁₋ₓ)O₃ (wobei 0 ≤ x ≤ 1) oder PZT) verwendet werden.

Nach der Sinterung können weiterhin auf zwei gegenüberliegenden Außenflächen des Vielschichtbauelements Außenelektroden aufgebracht werden. Dazu kann beispielsweise auf dem Stapel eine Grundmetallisierung eingebrannt werden. Die Innenelektroden sind vorzugsweise entlang der Stapelrichtung des Bauelements abwechselnd mit den Außenelektroden verbunden. Dazu sind die Innenelektroden beispielsweise abwechselnd bis zu einer der Außenelektroden geführt und weisen zur zweiten Außenelektrode einen Abstand auf. Auf diese Weise sind die Innenelektroden einer Polarität über eine gemeinsame Außenelektrode elektrisch miteinander verbunden.

In einem weiteren Aspekt betrifft die Erfindung durch das vorstehende Verfahren erhältliche Vielschichtbauelemente, wie etwa Aktoren und Kondensatoren.

Im Folgenden wird das angegebene Verfahren und seine vorteilhaften Ausgestaltungen anhand von schematischen und nicht maßstabsgetreuen Figuren sowie anhand eines Ausführungsbeispiels erläutert. Es zeigen:
- Figur 1: die schematische Seitenansicht eines durch das Verfahren hergestellten Vielschichtbauelements;
- Figur 2: a) und b) vergrößerte schematische Seitenansichten eines Vielschichtbauelements;
- Figur 3: a) bis d) lichtmikroskopische Aufnahmen (Vergrößerung 1:170 bzw. 1:150) eines Vielschichtbauelements im Profil nach Durchführung des Entbinderungsverfahrens, wobei das in den Schichten enthaltende Kupfer geschwärzt wurde; und
- Figur 4: Gleichgewichtskurven der Systeme Cu₂O/Cu, Pb/PbO, Zr/ZrO₂, Pb + TiO₂ + O₂/PbTiO₃, und Ni/NiO für unterschiedliche Sauerstoffpartialdrücke und Temperaturen.

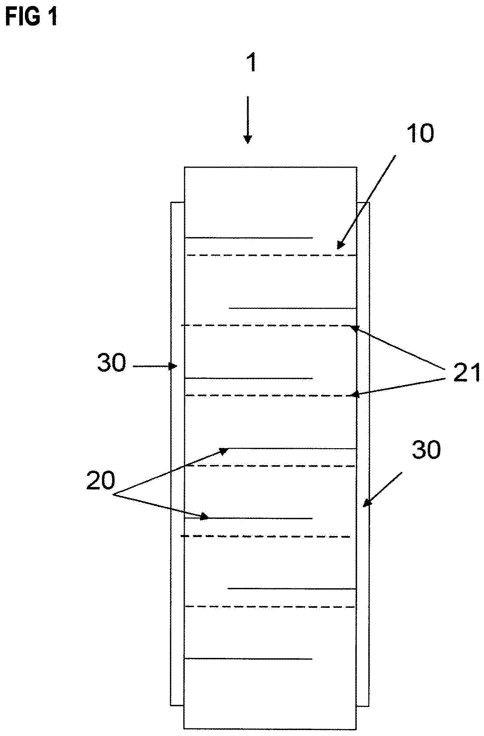

Figur 1 zeigt eine schematische Seitenansicht eines piezoelektrischen Vielschichtbauelements in Form eines Piezoaktors. Das Bauelement weist einen Stapel 1 aus übereinander angeordneten piezoelektrischen Schichten 10 und dazwischen liegenden Innenelektroden 20 auf. Die Innenelektroden 20 sind als Elektrodenschichten ausgebildet. Die piezoelektrischen Schichten 10 und die Innenelektroden 20 sind übereinander angeordnet. Zwischen piezoelektrischen Schichten 10 und parallel zu den Innenelektroden 20 sind Schwächungsschichten 21 in Figur 1 gezeigt. Die Schwächungsschicht 21 ist als Bereich zu verstehen, in dem Sollbruchstellen in dem Bauelement vorhanden sind.

Die piezoelektrischen Schichten 10 enthalten ein keramisches Material, zum Beispiel Blei-Zirkon-Titanat (PZT) oder eine bleifreie Keramik. Das Keramikmaterial kann auch Dotierstoffe enthalten. Die Innenelektroden 20 enthalten beispielsweise eine Mischung oder eine Legierung aus oder Cu und Pd.

Zur Herstellung des Stapels 1 werden beispielsweise Grünfolien, die ein Keramikpulver, ein organisches Bindemittel und ein Lösungsmittel enthalten, durch Folienziehen oder Foliengießen hergestellt. Auf einige der Grünfolien wird zur Bildung der Innenelektroden 20 eine Elektrodenpaste mittels Siebdruck aufgebracht. Weiterhin werden Lagen enthaltend ein Hilfsmaterial mit einer ersten und zweiten Komponente zur Bildung von Schwächungsschichten 21 auf eine oder mehrere Grünfolien aufgebracht. Die Grünfolien werden entlang einer Längsrichtung übereinander gestapelt und verpresst. Aus dem Folienstapel werden die Vorprodukte der Bauelemente in der gewünschten Form herausgetrennt. Schließlich wird der Stapel aus piezoelektrischen Grünfolien, Lagen aus Hilfsmaterial und Elektrodenschichten entbindert und gesintert. Nach dem Entbindern und Sintern werden weiterhin Außenelektroden 30 angebracht, die auch in Figur 1 gezeigt sind.

In der hier gezeigten Ausführungsform sind die Außenelektroden 30 auf gegenüberliegenden Seitenflächen des Stapels 1 angeordnet und verlaufen streifenförmig entlang der Stapelrichtung. Die Außenelektroden 30 enthalten beispielsweise Ag oder Cu und können als Metallpaste auf den Stapel 1 aufgebracht und eingebrannt werden.

Die Innenelektroden 20 sind entlang der Stapelrichtung abwechselnd bis zu einer der Außenelektroden 30 geführt und von der zweiten Außenelektrode 30 beabstandet. Auf diese Weise sind die Außenelektroden 30 entlang der Stapelrichtung abwechselnd mit den Innenelektroden 20 elektrisch verbunden. Zur Herstellung des elektrischen Anschlusses kann auf die Außenelektroden 30 ein Anschlusselement(hier nicht gezeigt), z. B. durch Löten, aufgebracht werden.

Anhand des folgenden Ausführungsbeispiels soll die Herstellung des in Figur 1 gezeigten Vielschichtbauelements, welches Schwächungsschichten 21 enthält, näher erläutert werden:

Zur Bildung des Stapels 1 werden auf mindestens eine Grünfolie eine Lage enthaltend ein Hilfsmaterial aufgebracht. Als Elektrodenmaterial wird eine CuPd-Paste auf Grünfolien aufgedruckt. Das Hilfsmaterial enthält CuO.

Wird nun beim Entbindern unter einer reduzierenden Atmosphäre, d.h. unter Verwendung eines Gleichgewichtspartialdrucks des Sauerstoffs zwischen den Kurven Pb/PbO und Cu₂O/Cu (so dass gleichzeitig PbO und Cu existent sind) liegt (vgl. Figur 4), eine Temperatur von 500 bis 600°C erreicht, bei der noch keine Verdichtung des Stapels 1 eintritt, diffundieren Kupferionen aus dem Hilfsmaterial in Richtung der benachbarten Elektrodenschichten 20. Zudem werden die Kupferionen und weiteres Kupferoxid aus dem Hilfsmaterial zu Kupfermetall reduziert. Dadurch wird die Lage enthaltend das Hilfsmaterial abgebaut und somit die Schwächungsschicht 21 gebildet. Die Porosität der Schwächungsschicht kann beispielsweise durch die Korngröße des verwendeten CuO eingestellt beziehungsweise beeinflusst werden.

Die Diffusion an sich wird begünstigt durch den Konzentrationsunterschied von Cu, das in der Lage enthaltend das Hilfsmaterial beziehungsweise enthaltend die aus dem Hilfsmaterial gebildeten Komponenten, und in dem Elektrodenmaterial vorhanden ist.

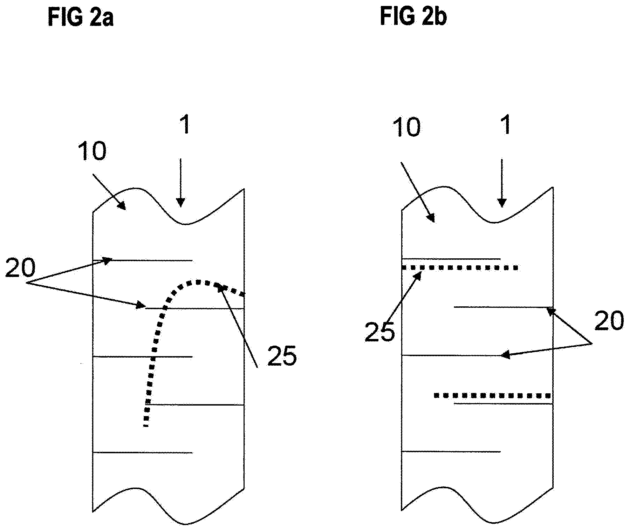

Figur 2a zeigt einen vergrößerten Ausschnitt der schematischen Seitenansicht des Vielschichtbauelements. Anhand dieser Figur soll die Rissbildung in Vielschichtbauelementen erläutert werden.

Das Bauelement dehnt sich beim Anlegen einer Spannung zwischen die Außenelektroden 30 in Längsrichtung aus. In einer so genannten aktiven Zone, in der sich in Stapelrichtung benachbarte Innenelektroden 20 überlappen, entsteht beim Anlegen einer Spannung an die Außenelektroden 30 ein elektrisches Feld, sodass sich die piezoelektrischen Schichten 10 in Längsrichtung ausdehnen. In inaktiven Zonen in denen sich benachbarte Elektrodenschichten 20 nicht überlappen, dehnt sich der Piezoaktor nur geringfügig aus.

Aufgrund der unterschiedlichen Ausdehnung des Bauelements in den aktiven und inaktiven Zonen treten mechanische Spannungen im Stapel 1 auf. Derartige Spannungen können zu Polungs-und/oder Entlastungsrissen 25 im Stapel 1 führen.

Die Figur 2a zeigt einen Ausschnitt aus einem Stapel 1 aus piezoelektrischen Schichten 10 und Innenelektroden 20, bei dem ein Riss 25 im Stapel 1 entstanden ist. Der Riss 25 verläuft innerhalb der inaktiven Zone parallel zu den Innenelektroden 20, knickt beim Übergang in die aktive Zone ab und verläuft in der aktiven Zone durch benachbarte Innenelektroden 20 unterschiedlicher Polarität hindurch. Dies kann zu einem Kurzschluss der Innenelektroden 20 führen.

Figur 2b zeigt einen Ausschnitt aus einem Stapel 1 aus piezoelektrischen Schichten 10 und Innenelektroden 20, in dem ebenfalls ein Riss 25 entstanden ist. Hier verläuft der Riss 25 parallel zu den Innenelektroden 20. Bei einem derartigen Verlauf von Rissen 25 ist die Gefahr von Kurzschlüssen verringert.

Um einen derartigen Verlauf von Rissen 25 zu begünstigen, wird das Vielschichtbauelement gemäß dem oben genannten Verfahren hergestellt, so dass sich die Risse 25 gezielt im Bereich der Schwächungsschicht 21, in der eine Sollbruchstelle vorhanden ist, ausbilden.

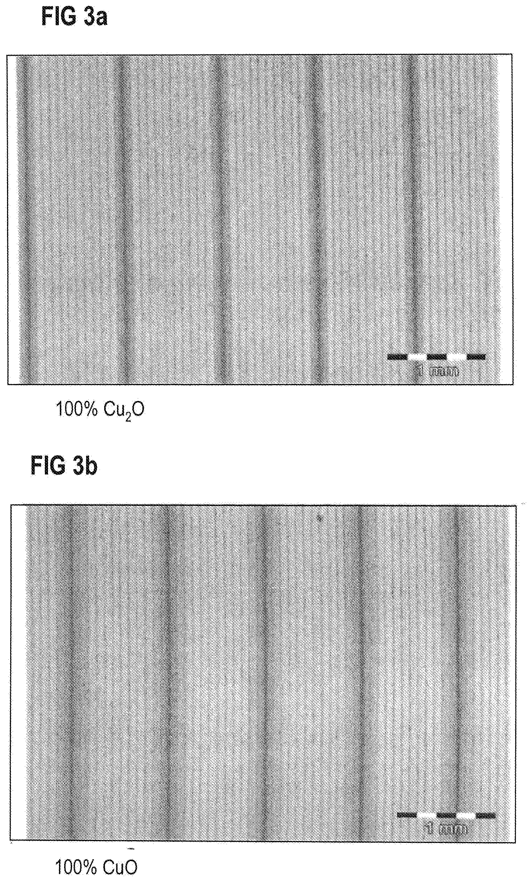

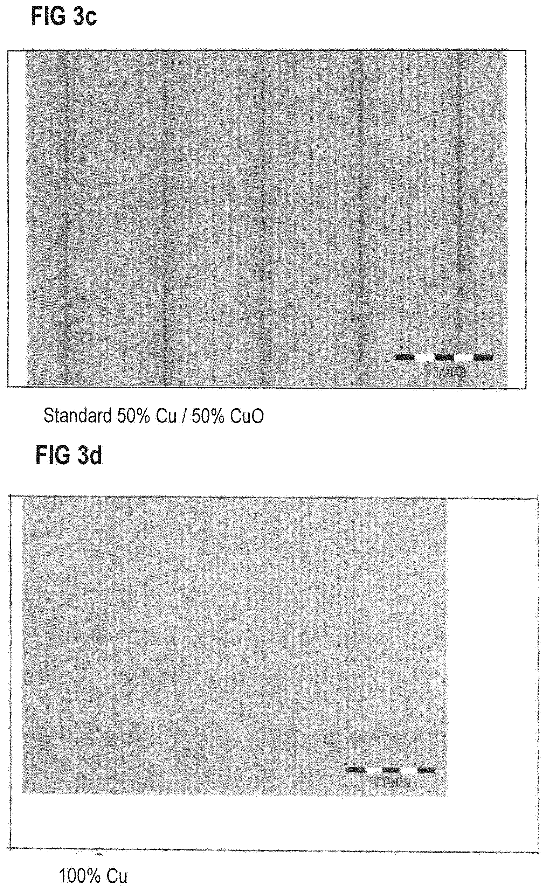

In Figuren 3a) bis d) werden lichtmikroskopische Aufnahmen (Vergrößerung 1:170 (Fig. 3a) bis c)) bzw. 1:150 (Fig. 3d)) eines Vielschichtbauelements im Profil nach Durchführung des Entbinderungsverfahrens unter einer reduzierenden Atmosphäre gezeigt. Hierbei wurden in Fig 3a) 100% Cu₂O; in Fig. 3b) 100% CuO; und in Fig. 3 c) 50% Cu/ 50% CuO verwendet. Fig. 3 d) zeigt ein Vielschichtbauelement ohne Schwächungsschichten zum Vergleich. Der Grad der Schwärzung in Figuren 3a) bis d) korreliert direkt mit dem Kupfergehalt in den keramischen Schichten. Der Nachweis konnte mit Laserablation in Kombination mit ICP/ MS erbracht werden. Die hier stattfindende Reaktion lautet: CuO -> Cu + 0.5 O₂ bzw. Cu₂O -> 2 Cu + 0.5 O₂. Kupferkationen diffundieren schneller als metallisches Kupfer. Je größer der Sauerstoffanteil der zugesetzten Cu-Komponente ist, desto stärker kommt es im Entbinderungsprozess zur Diffusion. Im Fall d) gibt es keine Kupferoxidkomponente, deshalb ist die Diffusion nicht stärker oder schwächer als bei allen anderen Cu Elektroden.

In Figur 3 a) reicht die von dem Hilfsmaterial ausgehende Schwärzung bis zu den beiden benachbarten Elektrodenschichten. In Fig. 3 b) umfasst die Schwärzung sogar zwei benachbarte Elektrodenschichten auf jeder Seite der Hilfsschicht. Aus einem Vergleich der Figuren 3 a) und 3 b) ergibt sich daher, dass der Bereich, in dem eine Schwärzung auftritt, in Fig. 3 b) ungefähr doppelt so groß wie in Fig. 3 a) ist. Daraus folgt, dass CuO (Oxidationszahl des Kupfers: 2) gegenüber Cu₂O als Hilfsmaterial bevorzugt ist, da zweiwertiges Kupfer einen höheren Diffusionsgrad und größere Diffusionslänge besitzt.
In Fig. 3 c), worin als Hilfsmaterial 50% Cu/ 50% CuO verwendet wird, ist die Schwärzung lokal begrenzt und dehnt sich nicht bis zu den benachbarten Elektrodenschichten aus. Diffusionsgrad und Diffusionslänge des Kupfers in dem der Hilfsschicht benachbarten Keramikmaterial gehen also zurück, wenn das Hilfsmaterial zusätzlich Kupfermetall (Oxidationszahl 0) enthält. Daher wird bevorzugt ein Hilfsmaterial verwendet, das kein Kupfermetall enthält.

### Bezugszeichenliste

- 1: Stapel
- 10: piezoelektrische Schicht
- 20: Innenelektrode
- 21: Schwächungsschicht
- 25: Riss
- 30: Außenelektroden

## Patentansprüche

1. Verfahren zur Herstellung eines Vielschichtbauelements umfassend die Schritte:
A) Bereitstellen eines Elektrodenmaterials und von Grünfolien, die ein dielektrisches Material enthalten,
B) Bereitstellen eines Hilfsmaterials, das mindestens ein Kupferoxid enthält,
C) Bilden eines Stapels (1), in dem abwechselnd dielektrische Grünfolien, mindestens eine Lage enthaltend das Hilfsmaterial und Schichten enthaltend das Elektrodenmaterial übereinander angeordnet sind,
D) Entbindern und Sintern des Stapels (1),
wobei während des Verfahrensschritts D) das Kupferoxid zu dem Kupfermetall reduziert wird und die mindestens eine Lage abgebaut wird, so dass ein Vielschichtelement aus dielektrischen Schichten mit dazwischen angeordneten Innenelektroden und mindestens einer Schwächungsschicht entsteht.

2. Verfahren nach dem vorhergehenden Anspruch, wobei das Elektrodenmaterial und das Hilfsmaterial so gewählt werden, dass sie ein gleiches Metall enthalten, das in dem Elektrodenmaterial zu einem geringeren Anteil vorhanden ist als in dem Hilfsmaterial.

3. Verfahren nach dem vorhergehenden Anspruch, wobei im Verfahrensschritt D) die Kupferionen aus dem Kupferoxid zu mindestens einer der Schichten enthaltend Elektrodenmaterial (20) hin diffundieren.

4. Verfahren nach einem der vorhergehenden Ansprüche, wobei im Verfahrensschritt D) der Sauerstoffpartialdruck so eingestellt wird, dass das Kupferoxid zu dem Kupfermetall reduziert wird.

5. Verfahren nach dem vorhergehenden Anspruch, wobei die Reduktion des Kupferoxids zu dem entsprechendem Kupfermetall bereits nach dem Entbinderungsprozess weitgehend abgeschlossen ist.

6. Verfahren nach dem vorhergehenden Anspruch, wobei durch die Diffusion im Bereich der Lage in dem Stapel (1) eine Schwächungsschicht (21) gebildet wird.

7. Verfahren nach einem der vorhergehenden Ansprüche, wobei als Kupferoxid CuO oder Cu₂O, vorzugsweise CuO, verwendet wird.

8. Verfahren nach einem der vorhergehenden Ansprüche, wobei das Hilfsmaterial kein Kupfermetall enthält.

9. Verfahren nach einem der vorhergehenden Ansprüche, wobei das Hilfsmaterial nur aus einer Komponente besteht.

10. Verfahren nach einem der vorhergehenden Ansprüche, wobei das Elektrodenmaterial Kupfer enthält.

11. Verfahren nach einem der vorhergehenden Ansprüche, wobei das dielektrische Material ein piezoelektrisches Material ist.

12. Vielschichtbauelement, erhältlich nach einem der Ansprüche 1 bis 11.

13. Vielschichtbauelement nach Anspruch 12, das als Aktor ausgestaltet ist.

14. Vielschichtbauelement nach Anspruch 12, das als Kondensator ausgestaltet ist.

## Claims

1. Method for producing a multi-layered structural element, comprising the following steps:
A) providing an electrode material and green sheets which contain a dielectric material,
B) providing an auxiliary material which contains at least one copper oxide,
C) forming a stack (1), in which dielectric green sheets, at least one ply containing the auxiliary material and layers containing the electrode material are arranged alternately one above another,
D) debindering and sintering the stack (1),
wherein, during method step D), the copper oxide is reduced to form the copper metal and the at least one ply is degraded, so that a multi-layered element consisting of dielectric layers with inner electrodes arranged therebetween and at least one weakening layer is formed.

2. Method according to the preceding claim, wherein the electrode material and the auxiliary material are selected in such a way that they contain the same metal, this being present in a smaller proportion in the electrode material than in the auxiliary material.

3. Method according to the preceding claim, wherein, in method step D), the copper ions diffuse from the copper oxide toward at least one of the layers containing electrode material (20).

4. Method according to one of the preceding claims, wherein, in method step D), the oxygen partial pressure is set in such a way that the copper oxide is reduced to form the copper metal.

5. Method according to the preceding claim, wherein the reduction of the copper oxide to form the corresponding copper metal has already largely concluded after the debindering process.

6. Method according to the preceding claim, wherein a weakening layer (21) is formed by the diffusion in the region of the ply in the stack (1).

7. Method according to one of the preceding claims, wherein the copper oxide used is CuO or Cu₂O, preferably CuO.

8. Method according to one of the preceding claims, wherein the auxiliary material does not contain any copper metal.

9. Method according to one of the preceding claims, wherein the auxiliary material consists only of one component.

10. Method according to one of the preceding claims, wherein the electrode material contains copper.

11. Method according to one of the preceding claims, wherein the dielectric material is a piezoelectric material.

12. A multi-layered structural element, obtainable according to one of Claims 1 to 11.

13. The multi-layered structural element according to Claim 12, which is embodied as an actuator.

14. The multi-layered structural element according to Claim 12, which is embodied as a capacitor.

## Revendications

1. Procédé de production d'un composant multicouche, comprenant les étapes consistant à :
A) fournir un matériau d'électrode et des feuilles crues contenant un matériau diélectrique,
B) fournir un matériau auxiliaire contenant au moins un oxyde de cuivre,
C) former un empilement (1) dans lequel des feuilles crues diélectriques, au moins une nappe contenant le matériau auxiliaire et des couches contenant le matériau d'électrode sont disposées de manière alternée les unes sur les autres,
D) délianter et fritter l'empilement (1),
dans lequel, pendant l'étape de procédé D), l'oxyde de cuivre est réduit en cuivre métallique et l'au moins une nappe est décomposée de manière à produire un élément multicouche constitué de couches diélectriques comportant des électrodes internes disposées entre celles-ci et au moins une couche de fragilisation.

2. Procédé selon l'une quelconque des revendications précédentes, dans lequel le matériau d'électrode et le matériau diélectrique sont sélectionnés de manière à ce qu'ils contiennent un même métal qui est présent dans le matériau d'électrode en proportion inférieure à celle du matériau auxiliaire.

3. Procédé selon la revendication précédente, dans lequel, lors de l'étape de procédé D), les ions cuivre diffusent depuis l'oxyde de cuivre vers au moins l'une des couches contenant le matériau d'électrode (20).

4. Procédé selon l'une quelconque des revendications précédentes, dans lequel, lors de l'étape de procédé D), la pression partielle d'oxygène est réglée de manière à ce que l'oxyde de cuivre soit réduit en cuivre métallique.

5. Procédé selon la revendication précédente, dans lequel la réduction de l'oxyde de cuivre en le cuivre métallique correspondant est déjà en grande partie achevée après le processus de déliantage.

6. Procédé selon la revendication précédente, dans lequel une couche de fragilisation (21) est formé du fait de la diffusion s'effectuant dans la zone de la nappe dans l'empilement (1).

7. Procédé selon l'une quelconque des revendications précédentes, dans lequel du CuO ou du Cu₂O, de préférence du CuO, est utilisé en tant qu'oxyde de cuivre.

8. Procédé selon l'une quelconque des revendications précédentes, dans lequel le matériau auxiliaire ne contient pas de cuivre métallique.

9. Procédé selon l'une quelconque des revendications précédentes, dans lequel le matériau auxiliaire n'est constitué que d'un seul constituant.

10. Procédé selon l'une quelconque des revendications précédentes, dans lequel le matériau d'électrode contient du cuivre.

11. Procédé selon l'une quelconque des revendications précédentes, dans lequel le matériau diélectrique est un matériau piézoélectrique.

12. Composant multicouche pouvant être obtenu conformément à l'une des revendications 1 à 11.

13. Composant multicouche selon la revendication 12, réalisé sous la forme d'un actionneur.

14. Composant multicouche selon la revendication 12, réalisé sous la forme d'un condensateur.
